# EUROPEAN PATENT APPLICATION

(11) **EP 3 886 188 A1**
(43) Date of publication of application: **29.09.2021**
(21) Application number: 19921694.6
(22) Date of filing: 10.05.2019
(51) Int. Cl.: H01L 35/12, H01L 35/28

(54) **SEMICONDUCTOR THERMOELECTRIC GENERATOR**

(30) Priority: 26.03.2019 UA 201902946
(71) Applicant: «Future In the Green Energy» Limited Liability Company, Brjanskaja obl., 243140 (RU)
(72) Inventor: KHVOROSTIANYI, Andrii Dmytrovych, Cherkaska obl., 20301 (UA); GENSEL, Andreas, 90530 Wendelstein (DE)
(74) Representative: Berggren Oy
(86) International application number: PCT/UA2019/000054
(87) International publication number: WO 2020/197525

(57) **Abstract**

The invention relates to thermoelectric generators, and more particularly to thermoelectric generators functioning on the thermoelectric properties of graded-gap structures, i.e. the properties of graded-gap semiconductors with alternating dopants and of heterojunctions therebetween, as well as on the properties of intrinsic semiconductor materials, and can be used, inter alia, for powering domestic electric appliances and charging power-supply elements of portable electronic devices.

The present semiconductor thermoelectric generator comprises a semiconductor assembly configured to be capable of extracting heat from the surrounding environment, said semiconductor assembly containing at least one pair of interconnected graded-gap semiconductors, wherein a wide-gap side of at least one graded-gap semiconductor is connected to a narrow-gap side of at least one other graded-gap semiconductor. The junction between the graded-gap semiconductors is configured using an intrinsic semiconductor material and the graded-gap semiconductors are configured using alternating dopants, wherein the wide-gap sides of pairwise-connected graded-gap semiconductors are doped with an acceptor impurity.

The technical result of the claimed invention consists in improving the efficiency, power and output of a thermoelectric generator and expanding the functionality thereof.

## Description

The invention relates to thermoelectric generators, and more particularly to thermoelectric generators functioning on the thermoelectric properties of graded-gap structures, i.e. the properties of graded-gap semiconductors with alternating dopants and of heterojunctions therebetween, as well as on the properties of intrinsic semiconductor materials, and can be used, inter alia, for powering domestic electric appliances and charging power-supply elements of portable electronic devices.

The prior art discloses the thermal element (patent RU 2248647 C2, IPC H01L 35/08, published on 20.03.2005, Bulletin No. 8) configured with at least one n-layer and at least one p-layer of one or several extrinsic semiconductors, while n-layer (layers) and p-layer (layers) are arranged so that they form at least one p-n junction, wherein, at least one n-layer and at least one p-layer are selectively in electric contact, and temperature gradient is applied or removed in parallel to boundary layer between at least one n- and p-layer, wherein, at least one p-n junction is formed actually along common predominantly the longest extension of n-layer (layers) and p-layer (layers) and thus, actually, along their common boundary layer.

The disadvantageous features of the known solution are poor efficiency, power, output, unreliability, reduced functionality, which are caused by its design, in particular, by making the semiconductors uniformly doped and without band-gap width gradient, and also by selective contact of semiconductors through the boundary layer, which essentially comprises a conductor.

The known solution has poor efficiency, power and output because use of the uniformly doped semiconductors without gap gradient does not allow to obtain the current of sufficient power for powering the majority of domestic electric appliances, rapid charging the batteries of portable electronic devices due to small difference in semiconductor Fermi quasi-levels and limited number of generated electron-hole pairs. Despite the fact that the known solution has a p-n junction between the semiconductors, use of conductor materials in the boundary layer decreases the amount of the generated current, since such conductors as gold used in the embodiment of the known solution for semiconductor contact do not have a band-gap. Insufficient power of the generated current in turn limits the functionality of the known solution, since it limits a range of devices which this solution is able to energize or charge.

Gradient of semiconductor doping with one type impurity, which is in one of the embodiments of the known solution, does not allow to improve efficiency substantially, increase number of electrons and holes generating electric current in thermoelectric processes, and, correspondingly, to increase the thermal element power as a whole, since diffusion and drift currents occurring in semiconductors require motion of main and auxiliary charge carriers.

The prior art also discloses an energy generator for a vehicle (patent US 2017211450 A1, IPC F01N 5/02, H01L 35/22, H01L 35/30, H01L 35/32, published on 27.07.2017), which includes a thermoelectric converter comprising n-type semiconductor, p-type semiconductor, intrinsic semiconductor between them, wherein, the intrinsic semiconductor band-gap width is smaller than the band-gap width of n-type semiconductor and p-type semiconductor, and also includes a channel for fluid heat carrier passage configured to supply heat to the thermoelectric converter, and the thermoelectric converter is installed relative to the heat carrier channel so that intrinsic semiconductor surface is perpendicular to the heat carrier flow.

The disadvantageous features of the known solution are poor efficiency, power, output and reduced functionality, which are caused by design of its thermoelectric converter, namely, by making the semiconductors without band-gap width gradient.

The known solution has poor efficiency, power and output because use of the uniformly doped semiconductors without band-gap width gradient does not allow to obtain the current of sufficient power for powering the majority of domestic electric appliances, rapid charging the batteries of portable electronic devices due to small difference in semiconductor Fermi quasi-levels and limited number of generated electron-hole pairs. Despite the availability of the intrinsic semiconductor which is located between n-type semiconductor and p-type semiconductor and is a source of additional electrons, the amount of current generated by the known solution, among other things owing to availability of p-n junction, is limited, since the known solution could be used for charging or powering the limited range of devices only.

The prior art closest to the claimed invention is the thermoelectric generator (patent UA 118506 C2, IPC H01L 35/00, published on 25.01.2019, Bulletin No. 2) including the semiconductor assembly configured to extract heat from the surrounding environment. The thermoelectric generator comprises at least one pair of interconnected graded-gap semiconductors consisting of p-type graded-gap semiconductor and n-type graded-gap semiconductor, wherein the wide-gap side P of at least one p-type graded-gap semiconductor is connected with the narrow-gap side n of at least one n-type graded-gap semiconductor, and if at least one more pair of graded-gap semiconductors is available, the wide-gap side N of at least one n-type graded-gap semiconductor is connected with the narrow-gap side p of at least one p-type graded-gap semiconductor.

Despite the numerous advantages of the closest solution, such as improved efficiency, no need for maintaining temperature difference at semiconductor contacts, cost-effectiveness, simple design and ease of use, manufacture cost reduction, enhanced functionality and scope of use, caused by use of graded-gap semiconductors and heterojunctions between them, mutual arrangement of graded-gap semiconductors, in particular, their wide band-gap and narrow band-gap sides, the closest solution is characterized by insufficiently high output per unit area, since the graded-gap semiconductors of the closest solution are uniformly doped. i.e. comprising either acceptor or donor impurities, that decreases the difference in graded-gap semiconductor Fermi quasi-levels and limits generation of electron-hole pairs.

Besides, the closest solution does not comprise semiconductor intrinsic materials, that also limits generation of electron-hole pairs in thermoelectric processes, which occur during functioning of the closest solution, and thus, limits power of diffusion and drift currents. Whereas, the reduced output of the closest solution, which is due to the design features of its semiconductor assembly and contact elements, drives the need for increasing the area of graded-gap semiconductors and contact elements, increasing the overall dimensions of the thermoelectric generator as a whole, that complicates the use of the closest solution and results in increased material consumption.

The technical problem to be solved by the claimed invention is creation of a new semiconductor thermoelectric generator, which is characterized by improved efficiency, power, output and enhanced functionality.

The said technical problem is solved by the fact that in the semiconductor thermoelectric generator, which includes the semiconductor assembly configured to extract heat from the surrounding environment, comprising at least one pair of interconnected graded-gap semiconductors, wherein, the wide-gap side of at least one graded-gap semiconductor is connected with the narrow-gap side of at least one another graded-gap semiconductor, *according to the proposal,* the point of graded-gap semiconductors junction is configured using semiconductor intrinsic material, and both graded-gap semiconductors are configured using alternating dopants, while, the wide band-gap sides of at least one pair of graded-gap semiconductors are doped with an acceptor impurity.

Moreover, *according to the proposal,* the edge area of the narrow-gap side of one of the graded-gap semiconductors, located in the point of graded-gap semiconductors junction, is made of semiconductor intrinsic material.

Besides, *according to the proposal,* in the point of graded-gap semiconductors junction there is an intermediate layer of semiconductor intrinsic material, through which they are connected.

Also, *according to the proposal,* the outer surfaces of the semiconductor assembly have ohmic contacts, and one terminal is connected to each outer surface of the semiconductor assembly.

Moreover, *according to the proposal,* on the semiconductor assembly outer surfaces with ohmic contacts there are contact elements configured to extract heat from a heat carrier, and one terminal is connected to each outer surface of the semiconductor assembly.

Besides, *according to the proposal,* the semiconductor assembly includes a pair of graded-gap semiconductors, and each of them has the wide-gap side Sip, which comprises silicon doped with an acceptor impurity and the narrow-gap side Gej, which comprises intrinsic germanium, while, the narrow-gap side Geᵢ of one graded-gap semiconductor is connected with the wide-gap side Siₚ of the other graded-gap semiconductor, but not with the interconnected sides of graded-gap semiconductors, which are the outer surfaces of the semiconductor assembly, terminals are connected and there are ohmic contacts on the said outer surfaces.

Moreover, *according to the proposal,* the semiconductor assembly includes a pair of graded-gap semiconductors, one of which has the wide-gap side Sip, which comprises silicon doped with an acceptor impurity and the narrow-gap side Geₙ, which comprises germanium with a donor impurity, the other graded-gap semiconductor has the wide-gap side Siₚ, which comprises silicon doped with an acceptor impurity and the narrow-gap side Gei, which comprises intrinsic germanium, between the narrow-gap side Geₙ of one graded-gap semiconductor and the wide-gap side Siₚ of the other graded-gap semiconductor there is an intermediate layer of intrinsic germanium Gei through which the graded-gap semiconductors are connected, but not to the sides of graded-gap semiconductors connected with the intermediate layer, which are the outer surfaces of the semiconductor assembly, terminals are connected and there are ohmic contacts on the said outer surfaces.

Besides, *according to the proposal,* the semiconductor assembly includes a pair of graded-gap semiconductors, and each of them has the wide-gap side Sip, which comprises silicon doped with an acceptor impurity and the narrow-gap side Geₙ, which comprises germanium with a donor impurity, while, between the narrow-gap side Geₙ of one graded-gap semiconductor and the wide-gap side Siₚ of the other graded-gap semiconductor there is an intermediate layer of intrinsic germanium Gei through which the graded-gap semiconductors are connected, but not to the sides of graded-gap semiconductors connected with the intermediate layer, which are the outer surfaces of the semiconductor assembly, terminals are connected and there are ohmic contacts on the said outer surfaces.

The technical result of the claimed invention consists in improving the efficiency, power and output of the thermoelectric generator and expanding the functionality thereof.

Cause-and-effect relationship between the essential features of the invention and the expected technical result is as follows.

The set of essential features of the claimed invention ensures the above stated technical result due to improving the semiconductor assembly design, namely, providing the semiconductor assembly with a point of graded-gap semiconductors junction, which is configured using semiconductor intrinsic material, graded-gap semiconductors which wide band-gap sides are doped with acceptor impurities, and narrow band-gap sides are doped with donor impurities or made of semiconductor intrinsic material.

The claimed semiconductor thermoelectric generator has improved efficiency, power and output due to the following reasons.

Owing to graded-gap design of the semiconductors, i.e. they are made of chemical elements or their compounds with different band-gap width, each of the semiconductor assembly semiconductors has a wide-gap side comprising a chemical element or compound of wider band-gap width, and a narrow-gap side comprising a chemical element or compound of narrower band-gap width than the width of the corresponding wide-gap side material. Further, due to semiconductor graded-gap nature the band-gap width is gradually reduced together with gradual change in the semiconductor chemical composition in one direction, from the wide-gap side to the narrow-gap side. Such design of the semiconductors together with variable doping and the wide-gap side doping with an acceptor impurity enables, when heating the contact surfaces of ohmic contacts with the surrounding environment or heat carrier and followed by uniform heating of graded-gap conductors, to obtain an electromotive force, which moves free charge carriers from the narrow-band sides of graded-gap conductors, where concentration of the said charge carriers is higher, to the wide-band sides of graded-gap conductors, where concentration of the said charge carriers is lower.

Thus, diffusion current occurs in graded-gap conductors in the direction from the narrow-gap side, which has high concentration of free charge carriers, to the wide-gap side, which has lower concentration of charge carriers. Moreover, the variable doping significantly increases the electromotive force, since due to equalization of Fermi quasi-levels between the sides of the graded-gap semiconductor doped as stated above, the built-in field occurs, which matches the field caused by the semiconductor graded-gap structure, that results in strengthening of the latter, and also provides the graded-gap semiconductor sides with the necessary amount of main and auxiliary charge carriers. Due to occurrence of the said diffusion current the space charges occur in the opposite parts of graded-gap semiconductors, that results in occurrence of drift current which direction is opposite to the diffusion current direction.

At the same time, the above stated design of the semiconductor assembly and graded-gap semiconductors causes occurrence of reverse voltage, heterojunction bias, occurrence of thermal current and thermal generation current in the point of graded-gap semiconductors junction, which forms the heterojunction. Thus, auxiliary charge carriers move through the heterojunction. Moreover, the electromotive force occurring in graded-gap semiconductors promotes motion of auxiliary charge carriers through the heterojunction also from the graded-gap semiconductor narrow-band sides to the semiconductor wide-band sides with converting them into the main charge carriers and with amplification of diffusion and drift current in graded-gap semiconductors.

At the same time, the intrinsic material located in the point of graded-gap semiconductors junction is the source of charge carriers as electrons, as holes in the amount necessary for maintaining the amplified thermal generation current in the heterojunction.

Thus, cumulative current generated by the claimed semiconductor thermoelectric generator consists of diffusion and drift current in graded-gap semiconductors, thermal current and thermal generation current in the heterojunction, located in the point of graded-gap semiconductors junction, and is more powerful than diffusion and drift current generated by the closest prior art, while the overall dimensions and area of graded-gap semiconductors are the same or smaller, that is indicative of improving the thermoelectric generator efficiency and output per unit area. Increased current power in turn enables to enhance functionality and scope of use of the claimed semiconductor thermoelectric generator, since it enables to charge or energize the devices which require more powerful current sources, that enables to use the claimed thermoelectric generator in cases when use of the closest prior art and any similar thermoelectric generators is not possible.

Improving the efficiency of the claimed thermoelectric generator is achieved due to the fact that at the above stated design of the semiconductor assembly the Seebeck effect is not used for current generation, that in turn eliminates the need for energy consumption to maintain temperature difference at semiconductor contacts and simultaneous heating and cooling of semiconductors, and also need for using sophisticated equipment for the above stated operations. Actually, efficient operation of the claimed thermoelectric generator requires heating the semiconductor assembly outer surfaces only, that could be done by simple contact of the said constitutive elements with emission in the surrounding environment or with heated heat carrier, such as air or water, while such heating could be a side effect of the other device operation, e.g. boiler or solar collector. At the same time, the most part of thermal energy, which heats the contact surfaces of ohmic contacts, is converted into thermal motion of charge carriers in graded-gap semiconductors, and thermal energy released by the thermoelectric generator during operation is dissipated in the enclosed volume with heat carrier and could be used for heating contact surfaces of ohmic contacts.

Moreover, use of the claimed thermoelectric generator becomes more user-friendly and easy owing to reducing the overall dimensions of the semiconductor thermoelectric generator, in particular, its area, since use of the thermoelectric generator with small area graded-gap semiconductors or assembly of such thermoelectric generators arranged in parallel is sufficient to generate powerful current.

Providing the semiconductor assembly outer surfaces with ohmic contacts enables to reduce a potential barrier between a semiconductor and ohmic contact metal that reduces the electromotive force consumption for charge carriers to pass through the said barrier, that in turn reduces energy consumption and improves the output and efficiency of the claimed thermoelectric generator. Connection of a terminal to each outer surface of the semiconductor assembly is necessary to connect the claimed thermoelectric generator to a load, current-to-voltage converter or other similar device and to form an electrical circuit.

Fixing the contact elements configured to extract heat from a heat carrier to the semiconductor assembly outer surfaces with ohmic contacts makes the use of the claimed thermoelectric generator more user-friendly, since it eliminates the need for fixing the said contact elements to means and devices which comprise or transfer a heat carrier, and makes the claimed semiconductor thermoelectric generator ready for installation into any suitable device or means to transfer heat carrier without additional operations and corresponding time consumption.

Design of the claimed semiconductor thermoelectric generator is clarified by the following figures.

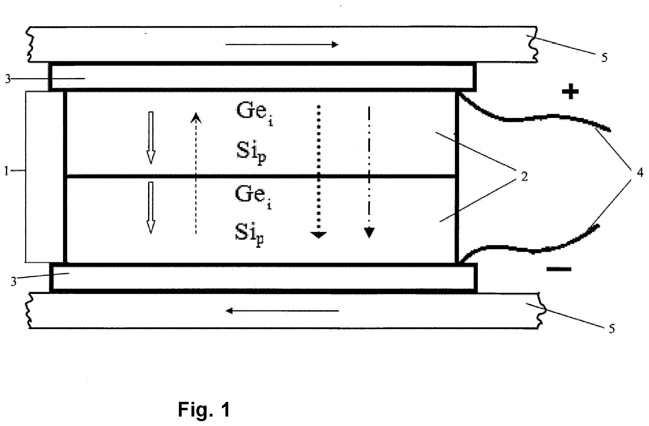

Fig. 1 - View of the claimed semiconductor thermoelectric generator in the embodiment where the semiconductor assembly includes a pair of graded-gap semiconductors, and each of them has the wide-gap side Sip, which comprises silicon doped with an acceptor impurity, and the narrow-gap side Gei, which comprises intrinsic germanium, while, the narrow-gap side Gej of one graded-gap semiconductor is connected with the wide-gap side Siₚ of the other graded-gap semiconductor, but not with the interconnected sides of graded-gap semiconductors, which are the outer surfaces of the semiconductor assembly, terminals are connected and there are ohmic contacts on the said outer surfaces.

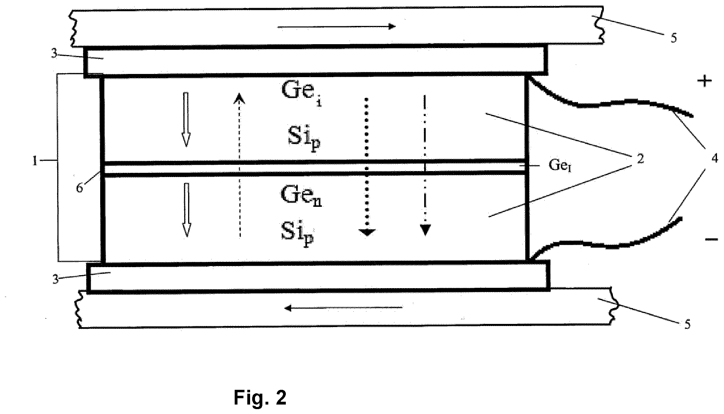

Fig. 2 - View of the claimed semiconductor thermoelectric generator in the embodiment where the semiconductor assembly includes a pair of graded-gap semiconductors, one of which has the wide-gap side Sip, which comprises silicon doped with an acceptor impurity and the narrow-gap side Geₙ, which comprises germanium with a donor impurity, the other graded-gap semiconductor has the wide-gap side Siₚ, which comprises silicon doped with an acceptor impurity, and the narrow-gap side Gei, which comprises intrinsic germanium, between the narrow-gap side Geₙ of one graded-gap semiconductor and the wide-gap side Siₚ of the other graded-gap semiconductor there is an intermediate layer of intrinsic germanium Geᵢ through which the graded-gap semiconductors are connected, but not to the sides of graded-gap semiconductors connected with the intermediate layer, which are the outer surfaces of the semiconductor assembly, terminals are connected and there are ohmic contacts on the said outer surfaces.

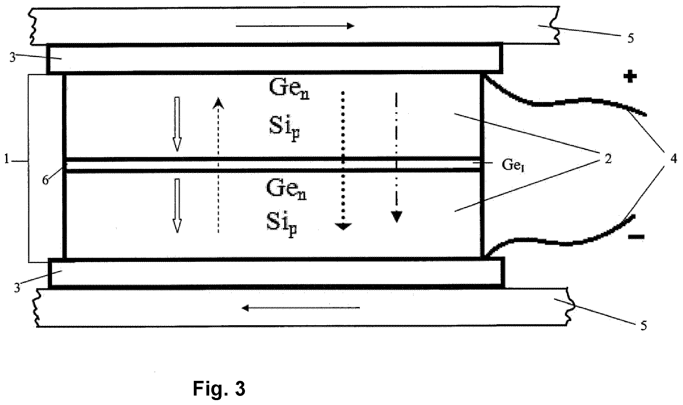

Fig. 3 - View of the claimed semiconductor thermoelectric generator in the embodiment where the semiconductor assembly includes a pair of graded-gap semiconductors, and each of them has the wide-gap side Sip, which comprises silicon doped with an acceptor impurity, and the narrow-gap side Geₙ, which comprises germanium with a donor impurity, while, between the narrow-gap side Geₙ of one graded-gap semiconductor and the wide-gap side Siₚ of the other graded-gap semiconductor there is an intermediate layer of intrinsic germanium Ge_{I} through which the graded-gap semiconductors are connected, but not to the sides of graded-gap semiconductors connected with the intermediate layer, which are the outer surfaces of the semiconductor assembly, terminals are connected and there are ohmic contacts on the said outer surfaces.

The following conventions are used in Figures:
Siₚ - graded-gap semiconductor wide-gap side consisting of silicon doped with an acceptor impurity in the embodiment;
Gej - graded-gap semiconductor narrow-gap side consisting of intrinsic germanium in the embodiment;
Geₙ - graded-gap semiconductor narrow-gap side consisting of germanium with donor impurity in the embodiment;
Gei - intermediate layer of intrinsic germanium

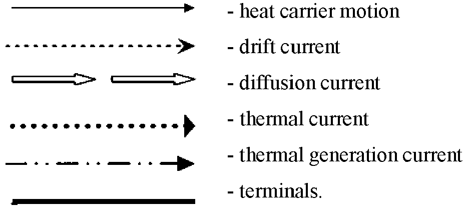

The Figures illustrate schematic views of the preferred but not exclusive embodiments of the claimed semiconductor thermoelectric generator, which includes a semiconductor assembly 1 comprising a pair of interconnected graded-gap semiconductors 2, two ohmic contacts 3 and two terminals 4. Besides, the Figures illustrate schematically and in simplified form the directions of diffusion and drift current, thermal current and thermal generation current, and also structure and materials of the graded-gap semiconductors 2.

Thermoelectric generator or thermogenerator in this case means a device which converts thermal energy into electric current.

In the illustrated embodiments the semiconductor assembly 1 comprises a pair of interconnected graded-gap semiconductors 2 variably doped. In the preferable embodiment the graded-gap semiconductors 2 are integrally connected with each other or with the intermediate layer 6 by soldering, splicing or any other similar method forming a heterojunction in the junction point of the pairwise-connected graded-gap semiconductors 2. The wide-band sides of the pairwise-connected graded-gap conductors 2 are doped with acceptor impurity.

The junction point of the pairwise-connected graded-gap semiconductors 2 is configured using semiconductor intrinsic material. In the embodiment of the claimed semiconductor thermoelectric generator illustrated in Fig. 1 the edge area of the narrow-gap side of one of the graded-gap semiconductors 2, located in the junction point of the graded-gap semiconductors 2, is made of semiconductor intrinsic material. In the embodiments of the claimed semiconductor thermoelectric generator illustrated in Fig. 2 and 3 in the point of graded-gap semiconductors junction there is an intermediate layer 6 of semiconductor intrinsic material, through which the graded-gap semiconductors 2 are connected. In all the above embodiments the semiconductor intrinsic material is germanium. However, such material could be any material which band-gap width is narrower than the band-gap width of the wide-band sides of the graded-gap semiconductors 2.

In the preferred embodiment illustrated in Fig. 1, each of the graded-gap semiconductors 2 consists of the wide-gap side Sip, which comprises silicon doped with an acceptor impurity, the narrow-gap side Gei, which comprises intrinsic germanium, and intermediate area between them with blend chemical composition, where germanium content is gradually decreased and silicon content is gradually increased in the direction to the wide-gap side.

In the preferred embodiment illustrated in Fig. 2, one of the graded-gap semiconductors 2 has the wide-gap side Siₚ, which comprises silicon doped with an acceptor impurity, and the narrow-gap side Geₙ, which comprises germanium with a donor impurity, the other graded-gap semiconductor 2 has the wide-gap side Sip, which comprises silicon doped with an acceptor impurity, and the narrow-gap side Gei, and between the narrow-gap side Geₙ of one graded-gap semiconductor 2 and the wide-gap side Sip of the other graded-gap semiconductor 2 there is the intermediate layer 6 of intrinsic germanium Gei, through which the graded-gap semiconductors 2 are connected.

In the preferred embodiment illustrated in Fig. 3, each of the graded-gap semiconductors 2 has the wide-gap side Siₚ, which comprises silicon doped with an acceptor impurity, and the narrow-gap side Geₙ, which comprises germanium with a donor impurity, while between the narrow-gap side Geₙ of one graded-gap semiconductor 2 and the wide-gap side Siₚ of the other graded-gap semiconductor 2 there is the intermediate layer 6 of intrinsic germanium Gei, through which the graded-gap semiconductors 2 are connected.

However, the graded-gap semiconductors 2 could be made of any semiconductor materials which have different band-gap width and could be combined in a graded-gap semiconductor taking the above conditions into account. Also, in the preferred embodiment the acceptor impurity for the wide band-gap sides of the graded-gap semiconductors 2 is trivalent boron, and the donor impurity for the narrow band-gap sides of the graded-gap semiconductors 2 in the corresponding embodiments is quinquivalent phosphorus. However, other similar materials in accordance with semiconductor materials, which compose the graded-gap semiconductors 2, could be used as acceptor and donor impurities.

In the illustrated embodiments of the claimed invention the graded-gap semiconductors 2 are in the form of plates and connected in the horizontal plane. The graded-gap semiconductors 2 can be produced by liquid phase epitaxy method, gaseous-phase ion-beam epitaxy method, diffusion method or by germanium or silicon sputtering on aluminum or nickel substrate. However, other materials, which correspond to the properties of graded-gap semiconductor materials, could be used as a substrate.

There are two ohmic contacts 3 on the outer surfaces of the semiconductor assembly 1, which are the outer surfaces of the graded-gap semiconductors 2. In the illustrated embodiment the ohmic contacts 3 are horizontally-oriented plates integrally connected with the outer surfaces of the semiconductor assembly 1, which are made of aluminum in the preferred embodiment of the claimed invention. However, the ohmic contacts 3 could be made of other material with high thermal conductivity, chemical resistance and resistance to high temperature.

Two terminals 4 are connected to the narrow-gap side of one graded-gap semiconductor 2 and to the wide-gap side of the other graded-gap semiconductor 2, which outer surfaces are the outer surfaces of the semiconductor assembly 1. In the preferred embodiment the terminals 4 are connected to the said surfaces of the graded-gap semiconductors 2 and to the ohmic contacts 3 and are coated with insulation. Material of the terminals 4 metal contacts could be, for example, copper or other chemical elements with apparent metallic properties.

In the illustrated embodiment the claimed semiconductor thermoelectric generator is located between two means for heat carrier 5 transfer, through which fluid or gaseous heat carrier passes. Such means for heat carrier transfer could be, for example, solar collector coil pipes, components of heating devices or other similar means.

The claimed semiconductor thermoelectric generator is used as follows.

The terminal 4 contacts are connected, for example, to a current-to-voltage converter, forming an electrical circuit and locate the claimed semiconductor thermoelectric generator between the heat carrier 5 transfer means so that the ohmic contacts 3 are in direct contact with the surfaces of the heat carrier 5 transfer means or with the contact elements configured to extract heat from the heat carrier in the corresponding embodiment of the claimed thermoelectric generator. After that, the heat carrier being in the said transfer means 5 is heated by an external heat source, for example, by means of fuel, gas or accumulated sun beams.

Thermal energy from the heat carrier passes through the ohmic contacts 3, through the outer surfaces of the semiconductor assembly 1 and heats the graded-gap semiconductors 2 uniformly, that starts operation of the claimed thermoelectric generator. Due to charge carriers motion between the sides of the graded-gap semiconductors 2 diffusion current, drift current, thermal current and thermal generation current occur through the heterojunction between the graded-gap semiconductors 2, while the directions of diffusion current, thermal current and thermal generation current are the same.

Thus, electric current occurs in the formed electrical circuit and is transferred through the terminals 4, for example, to the current-to-voltage converter or converters and could be used for powering domestic electric appliances, technical equipment, charging the batteries of portable electronic devices, etc.

At the same time, heating of the heat carrier 5 does not require considerable energy consumption and sophisticated equipment, and its rate is easily controlled by a user of the claimed semiconductor thermoelectric generator. In order to stop the claimed thermoelectric generator it is sufficient to disconnect wires of the terminals 4 from the device closing the electrical circuit or stop heating the heat carrier 5 or to remove the claimed semiconductor thermoelectric generator from the space between the heat carrier 5 transfer means.

At the same time, it is necessary to take into consideration that each of the above three preferred embodiments of the claimed semiconductor thermoelectric generator has optimal output at specific heat carrier temperature. Thus, the embodiment of the claimed semiconductor thermoelectric generator illustrated in Fig. 1 is used, if the heat carrier temperature equals or exceeds the temperature at which the narrow-gap side electrons of the graded-gap semiconductors 2 acquire energy required to convert into the charge carriers. The embodiment of the claimed semiconductor thermoelectric generator illustrated in Fig. 2 is used, if the heat carrier temperature equals or is below the temperature at which the narrow-gap side electrons of the graded-gap semiconductors 2 acquire energy required to convert into the charge carriers. The embodiment of the claimed semiconductor thermoelectric generator illustrated in Fig. 3 is used, if the heat carrier temperature is substantially below the temperature at which the narrow-gap side electrons of the graded-gap semiconductors 2 acquire energy required to convert into the charge carriers.

Also, in order to increase power of the generated current, several claimed thermoelectric generators could be connected in parallel through the metal contacts located between the outer surfaces of the semiconductor assemblies 1.

The existing sources of patent and scientific and technical information do not disclose a semiconductor thermoelectric generator which has the claimed set of essential features. therefore, the proposed technical solution complies with the novelty patentability criterion.

Comparative analysis of the above technical solution and the closest prior art has demonstrated that implementation of the set of essential features characterizing the proposed invention results in qualitatively new technical properties stated above, which combination has not been established before in the prior art, that enables to make a conclusion about compliance of the proposed technical solution with the inventive level patentability criterion.

The proposed technical solution is industrially applicable, since it does not comprise any structural elements and materials which cannot be reproduced at the modern technology development stage in industrial production surrounding environment.

## Claims

1. The semiconductor thermoelectric generator, which includes the semiconductor assembly configured to extract heat from the surrounding environment, comprising at least one pair of interconnected graded-gap semiconductors, wherein, the wide-gap side of at least one graded-gap semiconductor is connected with the narrow-gap side of at least one another graded-gap semiconductor, **characterized in that** the junction between graded-gap semiconductors is configured using semiconductor intrinsic material, graded-gap semiconductors are configured using alternating dopants, while, the wide band-gap sides of the pairwise-connected graded-gap semiconductors are doped with an acceptor impurity.

2. The semiconductor thermoelectric generator according to claim 1, **characterized in that** the edge area of the narrow-gap side of one of the graded-gap semiconductors, located in the junction between graded-gap semiconductors, is made of semiconductor intrinsic material.

3. The semiconductor thermoelectric generator according to claim 1, **characterized in that** in the junction between graded-gap semiconductors there is an intermediate layer of semiconductor intrinsic material, through which they are connected.

4. The semiconductor thermoelectric generator according to claim 1, **characterized in that** the outer surfaces of the semiconductor assembly have ohmic contacts, and one terminal is connected to each outer surface of the semiconductor assembly.

5. The semiconductor thermoelectric generator according to claim 1, **characterized in that** on the semiconductor assembly outer surfaces with ohmic contacts there are contact elements configured to extract heat from a heat carrier, and one terminal is connected to each outer surface of the semiconductor assembly.

6. The semiconductor thermoelectric generator according to claim 1, **characterized in that** the semiconductor assembly includes a pair of graded-gap semiconductors, and each of them has the wide-gap side Siₚ, which comprises silicon doped with an acceptor impurity and the narrow-gap side Gej, which comprises intrinsic germanium, while, the narrow-gap side Gej of one graded-gap semiconductor is connected with the wide-gap side Siₚ of the other graded-gap semiconductor, but not with the interconnected sides of graded-gap semiconductors, which are the outer surfaces of the semiconductor assembly, terminals are connected and there are ohmic contacts on the said outer surfaces.

7. The semiconductor thermoelectric generator according to claim 1, **characterized in that** the semiconductor assembly includes a pair of graded-gap semiconductors, one of which has the wide-gap side Siₚ, which comprises silicon doped with an acceptor impurity and the narrow-gap side Geₙ, which comprises germanium with a donor impurity, the other graded-gap semiconductor has the wide-gap side Siₚ, which comprises silicon doped with an acceptor impurity and the narrow-gap side Geⱼ, which comprises intrinsic germanium, between the narrow-gap side Geₙ of one graded-gap semiconductor and the wide-gap side Siₚ of the other graded-gap semiconductor there is an intermediate layer of intrinsic germanium Gei through which the graded-gap semiconductors are connected, but not to the sides of graded-gap semiconductors connected with the intermediate layer, which are the outer surfaces of the semiconductor assembly, terminals are connected and there are ohmic contacts on the said outer surfaces.

8. The semiconductor thermoelectric generator according to claim 1, **characterized in that** the semiconductor assembly includes a pair of graded-gap semiconductors, and each of them has the wide-gap side Siₚ, which comprises silicon doped with an acceptor impurity and the narrow-gap side Geₙ, which comprises germanium with a donor impurity, while, between the narrow-gap side Geₙ of one graded-gap semiconductor and the wide-gap side Siₚ of the other graded-gap semiconductor there is an intermediate layer of intrinsic germanium Gei through which the graded-gap semiconductors are connected, but not to the sides of graded-gap semiconductors connected with the intermediate layer, which are the outer surfaces of the semiconductor assembly, terminals are connected and there are ohmic contacts on the said outer surfaces.
